# EUROPEAN PATENT APPLICATION

(11) **EP 4 043 609 A1**
(43) Date of publication of application: **17.08.2022**
(21) Application number: 22158332.1
(22) Date of filing: 09.08.2019
(51) Int. Cl.: C23C 14/24, C23C 14/26, C23C 14/56, C23C 14/22, C23C 16/448, H01L 31/18

(54) **SYSTEMS FOR VAPORIZATION AND VAPOR DISTRIBUTION**

(30) Priority: 10.08.2018 US 201862717265 P
(62) Divisional of application: 19765576.4
(71) Applicant: First Solar, Inc., Tempe, AZ 85281 (US)
(72) Inventor: BARDEN, John, Perrysburg, OH 43551 (US); POWELL, Rick, Perrysburg, OH 43551 (US); ROGGELIN, Aaron, Perrysburg, OH 43551 (US); VORA, Nirav, Perrysburg, OH 43551 (US)
(74) Representative: D Young & Co LLP

(57) **Abstract**

Distributor assemblies for vapor transport deposition systems, and methods of conducting vapor transport deposition, are described.

## Description

### BACKGROUND

Thin film photovoltaic devices may contain several material layers deposited sequentially over a substrate, including semiconductor material layers which form a p-type absorber layer, an n-type window layer, or both. Vapor deposition is one technique which can be used for depositing semiconductor material layers over a substrate. In vapor deposition, a semiconductor material in solid form is vaporized under high temperatures with the vapor flow being directed towards a substrate where it condenses on the substrate a thin solid film. One such vapor deposition technique is known as vapor transport deposition (VTD). Exemplary VTD systems are described in U.S. Patents 5,945,163, 6,037,241, and 7,780,787.

Temperatures typically used for VTD deposition are in the range of from about 500 °C to about 1200 °C, with higher temperatures in this range being better for a high deposition throughputWhen the semiconductor material to be deposited contains tellurium, vaporization at the higher temperature can cause materials of components of the VTD system to also vaporize and chemically react with tellurium to form a tellurium chemical species vapor which can be deposited with the tellurium-containing semiconductor material. This, in turn, leads to undesired impurities being present in the deposited semiconductor film as a contaminant. If the impurities have a high enough concentration in the deposited film, they may adversely affect the electrical performance of the tellurium-containing semiconductor material.

It would be advantageous to discover alternative methods and apparatuses for vapor transport deposition.

### DRAWINGS

FIG. 1 schematically depicts a conventional vapor transport deposition (VTD) system.
FIG. 2 schematically depicts a cross-sectional view taken along the direction of line 2-2 of the VTD system of FIG. 1.
FIG. 3 schematically depicts a side perspective view of a processing system according to one or more embodiments shown and described herein.
FIG. 4 schematically depicts a cross-sectional view taken along the direction of line 4-4 of the distributor assembly of the processing system of FIG. 3 according to one or more embodiments shown and described herein. FIG. 4 is a Y-Z cross-section.
FIG. 5 schematically depicts a cross-sectional view taken along the direction of line 4-4 of the distributor assembly of the processing system of FIG. 3 according to one or more embodiments shown and described herein. FIG. 5 is a Y-Z cross-section.
FIG. 6 schematically depicts a cross-sectional view of a distributor assembly according to one or more embodiments shown and described herein. FIG. 6 is a X-Z cross-section.
FIG. 7 schematically depicts a cross-sectional view of a distributor assembly according to one or more embodiments shown and described herein. FIG. 7 is a X-Z cross-section.
FIG. 8 schematically depicts a cross-sectional view of a distributor assembly according to one or more embodiments shown and described herein. FIG. 8 is a X-Z cross-section.
FIG. 9 schematically depicts a cross-sectional view of a distributor assembly according to one or more embodiments shown and described herein. FIG. 9 is a X-Z cross-section.
FIG. 10 schematically depicts a cross-sectional view of a distributor assembly according to one or more embodiments shown and described herein. FIG. 10 is a X-Y cross-section.

### DETAILED DESCRIPTION

Provided herein are distributor assemblies for VTD systems, and methods of vapor transport deposition. The distributor assemblies and methods represent improvements in the filtering of powder particles and the prevention of contamination by elements such as silicon. The distributor assemblies provided herein, in some embodiments, can accommodate about 1,100 °C vaporization at high temperatures, without sourcing trace elements from the heating elements. The distributor assemblies and methods described herein generally involve the use of passive filter which is only indirectly heated, and heaters which are outside the vapor path and isolated from the filter.

In a VTD system, a semiconductor material in a powder form is continuously supplied to the interior of a permeable vaporization chamber with the assistance of a carrier gas. The vaporization chamber is heated to a high temperature sufficient to vaporize the powder, with the vapor passing through a permeable wall of the vaporization chamber. The vapor is then directed by a distributor towards, and condenses as a thin film on, a substrate which moves past one or more orifices of the distributor which directs the vapor towards the substrate.

In order to achieve a high production line throughput, each semiconductor material is generally deposited in a single stage deposition as a single layer on the substrate to a desired thickness. However, each semiconductor material may be deposited in multiple stages, such as two stages or three stages. To achieve the desired thickness with a high production speed, a substantial mass of semiconductor powder must be vaporized in a short time, which requires that the semiconductor powder be heated to a high temperature in the vaporization chamber.

VTD systems typically include a powder delivery unit, a powder vaporizer, a vapor distributor, and a vacuum deposition unit. VTD powder vaporizers are generally designed to vaporize or sublimate raw material powder into a gaseous form. In conventional powder vaporizers, raw material powder from a powder delivery unit is combined with a carrier gas and injected into a vaporizer formed as a permeable heated cylinder. The material is vaporized in the cylinder and the vaporized material diffuses through the permeable walls of the vaporizer into a vapor distributor. The distributor typically surrounds the vaporizer cylinder and directs collected vapors towards openings which face towards a substrate for thin film material deposition on the substrate.

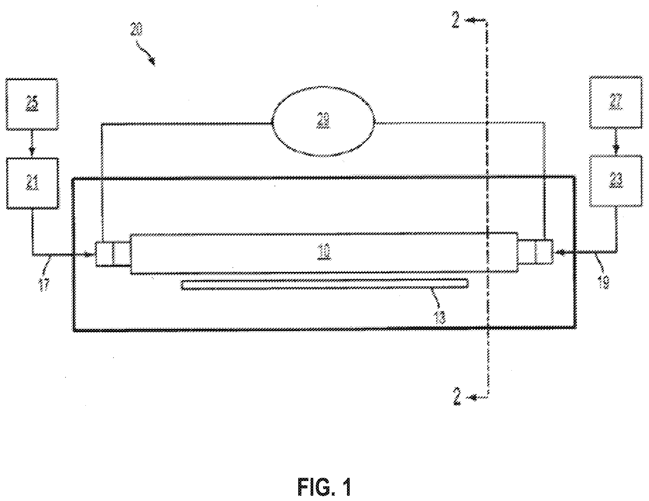

FIG. 1 illustrates an embodiment of a vapor transport deposition system 20 for delivering and depositing a semiconductor material, for example CdS or CdTe, onto a substrate 13, for example, the substrate 13 can be a glass substrate, used in the manufacture of thin film solar modules. Inert carrier gas sources 25 and 27, for example, Helium gas (He) or Nitrogen gas (N₂) sources, respectively, provide a carrier gas to powder feeders 21 and 23, which contain CdS or CdTe powder material. The carrier gas transports the semiconductor material through injector ports 17, 19 on opposite ends of a vaporizer and distributor assembly 10. The vaporizer and distributor assembly 10 vaporizes the semiconductor material powder and distributes it for deposition onto substrate 13.

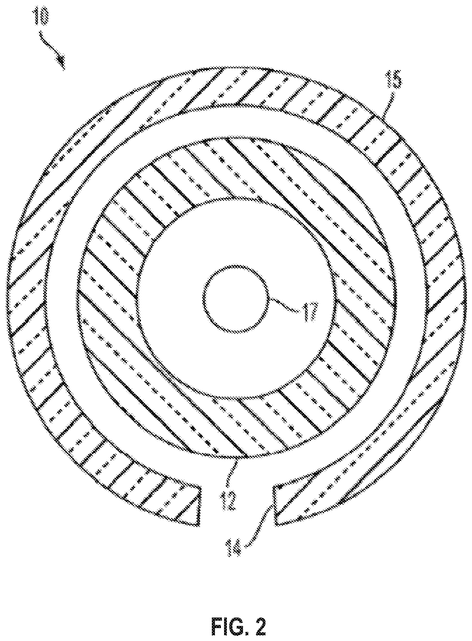

FIG. 2 is a cross-sectional view, taken along the section line 2-2 of FIG. 1, of one example of a powder vaporizer and distributor assembly 10. The vaporizer 12 is constructed as a heated tubular permeable member. It is formed of a resistive material which can be heated by the AC power source 29 and vaporizes, for example, a CdTe semiconductor material powder transported by the carrier gas into vaporizer 12 through injector ports 17, 19. The distributor 15 is a housing heated by radiant heat from vaporizer 12 and/or from another source. The housing of distributor 15 surrounds vaporizer 12 to capture CdTe semiconductor material vapor that passes through the walls of vaporizer 12. The semiconductor material vapor is directed by a distributor towards a slot or series of holes 14 which face a surface of a substrate 13, which moves past the vaporizer and distributor assembly 10.

Temperatures typically used for VTD deposition are in the range of from about 500 °C to about 1200 °C, with higher temperatures in this range being better for a high deposition throughput. The vaporizer 12 can be formed as a heatable tubular permeable member formed of silicon carbide (SiC). The distributor 15 can be formed of a shroud of ceramic material, such as mullite. Vapor deposition occurs within a housing which contains a substrate transport mechanism such as driven rollers. Ceramic sheets may also be used as heat shields within the housing. When the semiconductor material to be deposited contains tellurium, vaporization at the higher temperature can cause materials of the tubular permeable member, the mullite shroud, ceramic sheets, and other equipment associated with the deposition, to also vaporize and chemically react with tellurium to form a tellurium chemical species vapor which can be deposited with the tellurium-containing semiconductor material. This, in turn, leads to undesired impurities being present in the deposited semiconductor film as a contaminant. Some of these impurities may include titanium, cobalt, copper, vanadium, iron, antimony, zirconium, tin, silicon, and aluminum, which are known to have gas-phase telluride species, in addition to high vapor pressure elements such as sodium and potassium.

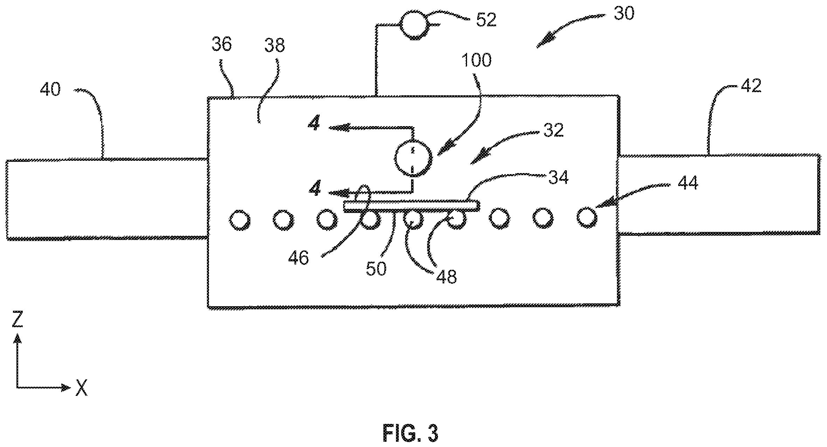

Referring now to FIG. 3 an embodiment of a processing system 30 is schematically depicted. The processing system 30 can include apparatus 32 constructed to perform a method of depositing material on a substrate 34. Both the apparatus 32 and the method of depositing the material are more fully described below. The processing system 30 can process a substrate 34 (for example, a glass sheet) for deposition of a material (for example, a semiconductor material, such as a II-VI semiconductor, including CdTe, and CdSe). The processing system 30 can include a housing 36 defining a processing chamber 38 in which a material is deposited on substrate 34. Housing 36 includes an entry station 40 and an exit station 42. The entry station 40 and exit station 42 can be constructed as load locks or as slit seals through which the glass sheet substrates 34 enter and exit the processing chamber 38. The interior of housing 36 can be heated in any desired processing temperature, as provided herein.

The processing system 30 can include a distributor assembly 100. The distributor assembly 100 can be located above a conveyor 44 so as to deposit the material on the upwardly facing surface 46 of the substrate 34. Furthermore, the conveyor 32 can be of the roll type including rolls 48 that support the downwardly facing surface 50 of the substrate 34 for its conveyance during processing. The distributor assembly 100 can be used with a vacuum drawn in the processing chamber 38 such as, for example, in the range of 1 to 50 Torr. Accordingly, the processing system 30 can include a suitable exhaust pump 52 for exhausting the processing chamber 38 of the housing 36 both initially and continuously thereafter to remove carrier gases and secondary gases.

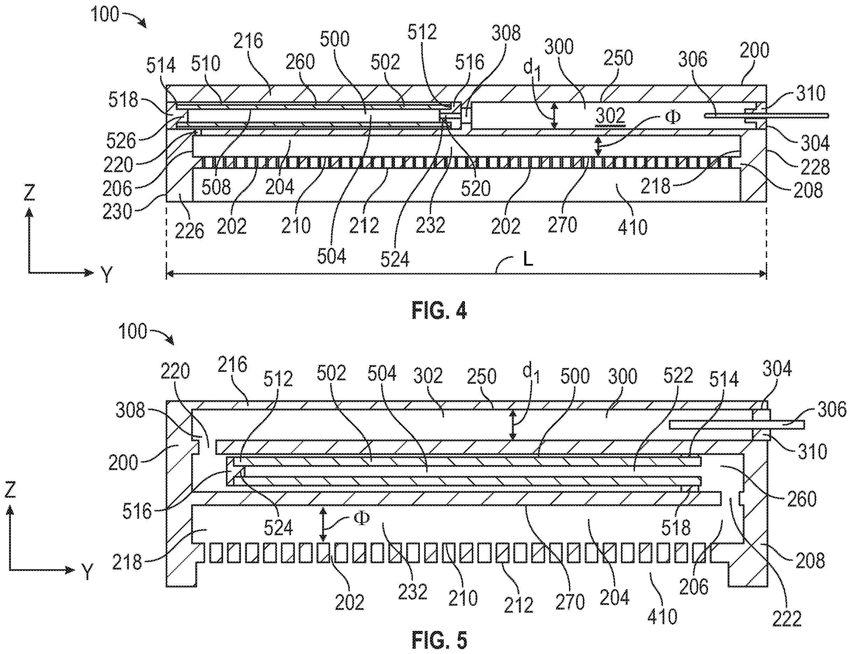

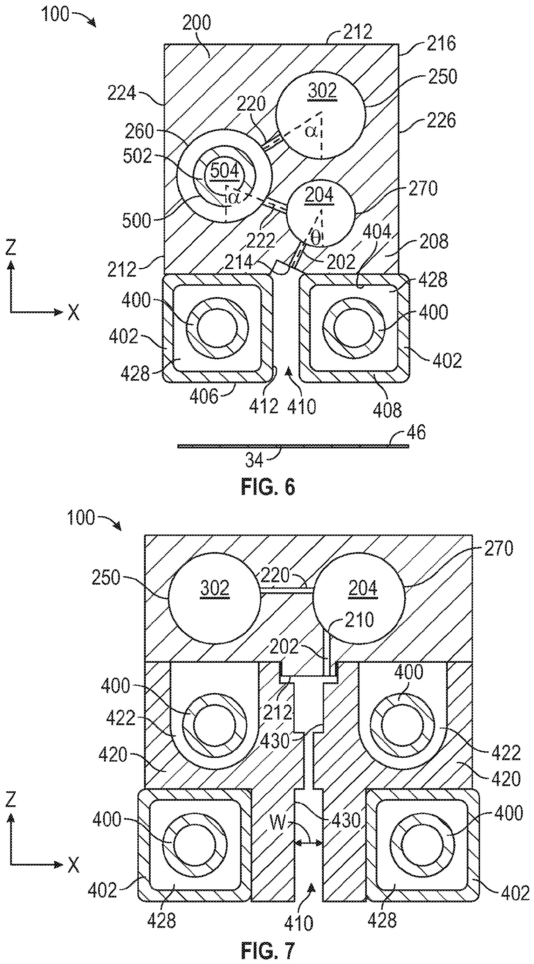

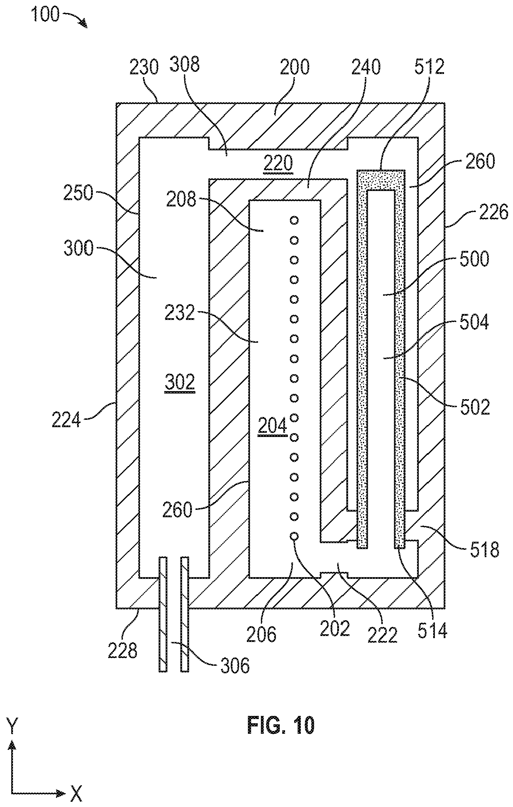

Referring to FIGS. 3-10, the direction of travel of the substrate 34 within the system 30 is referred to as being along the x-axis. The y-axis is in the plane of the substrate 34, substantially perpendicular to the direction of travel of the substrate 34. The z-axis is the plane substantially perpendicular to the plane of the substrate 34. Thus, FIGS. 4 and 5, which are cross-sectional views along line 4-4 in FIG. 3, may be referred to as Y-Z cross-sections of embodiments of the distributor assembly 100. FIGS. 6-9 are cross-sectional views of embodiments of the distributor assembly 100 that may be referred to as X-Z cross-sections. FIG. 10 is a cross-sectional view of an embodiment of a distributor assembly 100 that may be referred to as a X-Y cross-section.

Referring to FIGS. 4-9, embodiments of the distributor assembly 100 may include a manifold body 200, a vaporizer 300, a filter 500, and at least one heater 400. The manifold body 200 may further include a plurality of distribution jets 202 for directing a semiconductor vapor from the manifold body 200, such as toward the substrate 34. The distribution jets 202 may direct the semiconductor vapor out of a manifold cavity 204 within the manifold body 200.

The manifold body 200 may be formed as a one-body construction. A one-body construction of the manifold body 200 can result in truer spans compared to tubes formed from mullite, i.e., less curvature along a straight span. The manifold body 200 can be machined with a manifold cavity 204, distribution jets 202, bores 250, 260, 270, and crossovers 220, 222 that are precision defined. The manifold body 200 can be composed of a thermally conductive material and machined from materials such as, for example, graphite, carbon fiber composite (CFC), or the like. The material of the manifold body 200 can be a machinable and chemically stable material at operating temperatures. In some embodiments, the manifold body 200 is formed from materials more readily machinable than SiC. Alternatively, the manifold body 200 can be formed from SiC for enhanced resistance to oxidation. In some embodiments, as depicted in FIGS. 4 and 5, the manifold body 200 is a graphite body which houses the vaporizer 300, filter 500, manifold cavity 204, and distribution jets 202, the purposes of which are described in more detail below. The manifold body 200 can have a rectangular cross-section. In other embodiments, the manifold body 200 can have a circular cross-section. The shape of the cross-section of the manifold body 200 is not limited.

Referring still to FIGS. 4 and 5, the manifold body 200 may have a substrate facing portion 208 and an opposite side 216 which are separated by distance along the z-axis. Referring to FIGS. 6-10, the manifold body 200 may have a substrate entrance side 224 and a substrate exit side 226 which are separated by distance along the x-axis. Referring to FIG. 10, the manifold body 200 may have a first face 228 and a second face 230 which are separated by distance along the y-axis. In some embodiments, when depositing a semiconductor vapor on a substrate 34, the substrate 34 traverses the distributor assembly 100 along the x-axis from the substrate entrance side 224 to the substrate exit side 226 while disposed a distance below the substrate facing portion 208 along the z-axis. In some embodiments, the substrate 34 passes at a distance ranging from about 10 mm to about 50 mm along the z-axis below the distributor assembly 100. In one non-limiting example, the substrate 34 passes at a distance of about 30 mm below the distributor assembly 100 along the z-axis.

Referring to FIGS. 4-10, the manifold body 200 may include a plurality of bores 250, 260, 270. The term "bore" is used to refer to a hollowed out section of the manifold body 200. A bore may have a circular cross section, as seen for example in FIGS. 6 and 7, but does not need to have a circular cross section. For example, a bore may have a rectangular cross section or a trapezoidal cross section. The shape of the cross section of any bore is not particularly limited.

Referring now to FIGS. 4-6, the manifold body 200 may include a first bore 250, a second bore 260, and a third bore 270. The first bore 250, second bore 260, and third bore 270 are each hollowed out portions which extend for some distance along the y-axis within the manifold body 200. While embodiments with three bores 250, 260, 270 are described for example purposes, any number of bores may be formed in the manifold body 200 to accommodate any number of desired structures or functions.

Referring to FIG. 4, any of the bores 250, 260, 270 may extend along the y-axis for some or all of the length L of the manifold body 200. In some embodiments, one or more of the bores 250, 260, 270 extend along the y-axis for only a segment of the length L of the manifold body 200. For example, the third bore 270 may extend a longer distance along the y-axis than the first bore 250 or the second bore 260. In some embodiments, as seen in FIG. 4, the first bore 250 and the second bore 260 are coaxial along the y-axis within the manifold body 200. In some embodiments, as seen in FIG. 5, the first bore 250, the second bore 260, and the third bore 270 are parallel to each other along the y-axis within the manifold body 200 but are not coaxial along the y-axis.

Referring now to FIG. 6, the first bore 250 may be at a different position along the z-axis within the manifold body 200 than one or both of the second bore 260 and the third bore 270. The second bore 260 may be a different position along the z-axis within the manifold body 200 than one or both of the first bore 250 and the third bore 270. The third bore 270 may be at a different position along the z-axis within the manifold body 200 than one or both of the first bore 250 and the second bore 260. Alternatively, as seen for example in FIGS. 7-9, any two of the first bore 250, the second bore 260, and the third bore 270 may be at the same position along the z-axis within the manifold body 200, or all three of the first bore 250, the second bore 260, and the third bore 270 may be at the same position along the z-axis within the manifold body 200. As seen in FIGS. 4 and 5, the first bore 250, the second bore 260, and the third bore 270, may all be parallel to one another along the y-axis within the manifold body 200 while disposed at different positions along the z-axis within the manifold body 200.

Referring now to FIGS. 4 and 5, the manifold body 200 may further include a desired number of crossovers 220, 222, which are channels within the manifold body 200, to allow semiconductor vapor to flow from one location within the manifold body 200 to another location within the manifold body 200, such as between two bores. Crossovers 220, 222 may be machined out of the material used to make the manifold body 200, or may alternatively be preformed ports inserted into openings in the manifold body and held in place with suitable plugs such as graphite plugs. For example, as depicted in FIG. 4, the manifold body 200 may include a first crossover 220 configured to allow semiconductor vapor to flow from the second bore 260 to the third bore 270. As another example, as depicted in FIG. 5, the manifold body 200 may include a first crossover 220 configured to allow semiconductor vapor to flow from the first bore 250 to the second bore 260, and a second crossover 222 configured to allow semiconductor vapor to flow from the second bore 260 to the third bore 270. Thus, the crossovers 220, 222 allow the bores 250, 260, 270 to be in fluid communication with each other within the manifold body 200.

As seen in FIG. 6, the crossovers 220, 222 can be disposed at a port angle α with respect to the normal of the substrate 34 (i.e., with respect to the z-axis). The port angle α can be acute such as, for example, about 20° in one embodiment. However, the port angle α depends on the relative position of the bores 250, 260, 270 along the z-axis, and thus other port angles α are possible and encompassed within the present disclosure. Moreover, each crossover 220, 222 may be disposed at a different port angle α.

Referring to FIGS. 4-9, the manifold body 200 may include an exit slot 410, as described in more detail below. The exit slot 410 may have a different function than the bores 250, 260, 270 in that the exit slot 410 may direct semiconductor vapor out of the manifold body 200, but the exit slot 410 may similarly be defined by a hollowed out portion of the manifold body 200. The exit slot 410 may be a hollowed out portion extending from the distribution jets 202 to outside the manifold body 200. Alternatively, as seen in FIGS. 7-9 and described in more detail below, the exit slot 410 may be a channel entirely outside of the manifold body 200 which extends from the manifold body 200 through a space between vapor curtain beams 420 or support beams 402, or both vapor curtain beams 420 and support beams 402. In general, the exit slot 410 directs semiconductor vapor from the distribution jets 202 toward the substrate 34 along the z-axis.

Referring again to FIGS. 4 and 5, the distributor assembly 100 may include a vaporizer 300 configured to vaporize a powder of a semiconductor material, such as, but not limited to, a CdTe powder, a CdSe powder, or the like or combinations thereof, into a semiconductor vapor. The vaporizer 300 may be generally tubular in shape with an elongated construction, though the vaporizer 300 need not be tubular. The vaporizer 300 may define a vaporizer chamber 302 therein, within which vaporization may occur.

The vaporizer 300 may be formed from a material distinct from the manifold body 200, or may be formed as a cavity within the manifold body 200. In some embodiments, as depicted in FIGS. 4 and 5, the vaporizer chamber 302 is defined by a section of the first bore 250 in the manifold body 200. In other words, it is not necessary to insert any preformed structure into the manifold body 200 to form the vaporizer 300; rather, the vaporizer chamber 302 may simply be a hollowed-out area within the manifold body 200 where powder is vaporized into vapor. In alternative embodiments, the vaporizer 300 is a SiC tube which extends for some distance along the y-axis within the first bore 250. Thus, the vaporizer 300 may or may not be formed from a separate material or member from the manifold body 200. The vaporizer 300 can be supported on, attached to, or otherwise in thermal communication with the manifold body 200.

As seen in FIGS. 4, 5, and 7, the vaporizer chamber 302 may be disposed above the manifold cavity 204 relative to the substrate 34 along the z-axis. In other embodiments, the vaporizer chamber 302 is at about the same position along the z-axis as the manifold cavity 204. The vaporizer chamber 302 may be disposed at about the same position along the x-axis as the manifold cavity 204, as seen in FIG. 6, or may alternatively be disposed at a different position along the x-axis than the manifold cavity 204, as seen for instance in FIG. 7.

When formed from a separate structure than the manifold body 200, the vaporizer 300 is composed of a thermally conductive material. The vaporizer 300 may have a thermal conductivity of at least about 1 W/mK (W/m-K or W m⁻¹ K⁻¹) such as, for example, at least about 2 W/mK in one embodiment, or at least about 5 W/mK in another embodiment. In one non-limiting example, the vaporizer 300 has a conductivity of about 10 W/mK. Suitable materials for the vaporizer 300 include, but are not limited to, graphite, mullite, SiC, and conductive ceramics.

The vaporizer 300 may be heated during use. As seen in FIGS. 6-9, the distributor assembly 100 may include one or more heaters 400 configured to heat the vaporizer 300 by transferring heat through the manifold body 200. Heat from one or more heaters 400 may be delivered to the vaporizer 300 by the manifold body 200 so as to heat the vaporizer chamber 302 to a sufficient temperature to vaporize semiconductor powder therein. The heaters 400 may be disposed in direct contact with the manifold body 200, or may be disposed in direct contact with other structures or materials which are in direct contact with the manifold body 200, so as to transfer heat through the manifold body 200 to the vaporizer chamber 302. Alternatively or in addition, when the vaporizer 300 is formed from an electrically conductive material such as SiC, the vaporizer 300 can be heated by application of a voltage along the length of the vaporizer 300. The voltage may be applied by suitable electrical connections, and causes an electrical current to flow along the length of the vaporizer 300, electrically heating the vaporizer 300 during processing.

Once inside the vaporizer chamber 302, a semiconductor powder may be vaporized with sufficient temperature to form a semiconductor vapor. The vaporizer 300 may be heated by the one or more heaters 400 in order to achieve a temperature within the vaporizer chamber 302 sufficient to vaporizer the semiconductor powder into a semiconductor vapor. The temperature within the vaporizer chamber 302 which suffices to vaporize the semiconductor powder depends on the composition of the semiconductor powder. In some embodiments, the vaporizer 300 is heated such that the vaporizer chamber 302 is at a temperature ranging from about 850° C to about 1150° C. In some embodiments, the vaporizer chamber 302 is at a temperature ranging from about 950 °C to about 1,050 °C. However, other temperatures are possible and entirely encompassed within the scope of the present disclosure. As seen in FIGS. 6-8, the heater 400 may be close enough to the manifold body 200 such that the conductive nature of the manifold body 200 transfers heat from the heater 400 to the vaporizer 300 so as to vaporize the semicondcutor powder within the vaporizer chamber 302. If the material of the manifold body 200 surrounding the vaporizer 300 has high thermal conductivity and allows easy transfer of heat from the heater 400, overall operating temperatures can be reduced, which can be advantageous for reducing contaminats from components such as filter 500. In alternative embodiments, the vaporizer 300 may be directly heated to perform the function of vaporizing the semiconductor powder without substantially heating the manifold body 200. In such embodiments, a substantial portion (i.e., at least 70%, or at least 80%, or at least 90%) of the energy supplied to the vaporizer 300 may be utilized to vaporize the powder, and not to perform some other heating function (e.g., heating the manifold body 200).

Referring now to FIG. 4, the vaporizer 300 may be formed from or within the first bore 250. The first bore 250 may have a diameter d₁ that defines the vaporizer chamber 302 from the powder inlet 304 to the vapor outlet 308 along the y-axis. In some embodiments, as seen in FIG. 4, the vaporizer chamber 302 extends along the y-axis for about half the length L of the manifold body 200. In other embodiments, such as seen in FIG. 5, the vaporizer chamber 302 extends along the y-axis for nearly the entire length L of the manifold body 200.

Referring to FIGS. 4 and 5, the vaporizer 300 may include a powder inlet 304 which allows for entry into the vaporizer chamber 302. A powder injector 306 may be inserted into the powder inlet 304 for delivering semiconductor powder to the vaporizer chamber 302. The powder injector 306 may be a double feed tube where each feed tube is independently operable and removable, or may be a single feed tube. The powder injector 306 may be held in place in the powder inlet 304 with a feed tube retainer 310, which may be a graphite plug. The powder injector 306 can introduce a carrier gas and the semiconductor material to be deposited into the vaporizer 300. However, it is not strictly necessary to inject a carrier gas. When no carrier gas is used, a purge gas may be used to prevent the pressure from powder vaporization from causing backflow and condensation in the powder injector 306. Furthermore, as seen in FIGS. 4, 5, and 10, the distributor assembly 100 may feature single-side feed. In other words, the powder injector 306 may be inserted into only one side of the manifold body 200 along the y-axis, namely in the first face 228 of the manifold body 200. In alternative embodiments, the vaporizer 300 may include multiple powder inlets 304 and multiple powder injectors 306 on more than one side of the manifold body 200 along the y-axis.

Referring now to FIG. 4, the vaporizer 300 may extend along the y-axis for only a segment of the length L of the manifold body 200, and other components of the distributor assembly 100 may therefore also be housed at the same position along the z-axis, and the same position along the x-axis, within the manifold body 200 as the vaporizer 300. As seen in FIG. 4, the vaporizer 300 and the first bore 250 may be coaxial with the filter 500 and the second bore 260. The filter 500 may be disposed within the second bore 260 at the same position along the z-axis, and the same position along the x-axis, within the manifold body 200 as the vaporizer 300.

Referring to FIG. 6, the vaporizer chamber 302 may be disposed above the manifold cavity 204 along the z-axis within the manifold body 200, though the vaporizer chamber 302 may be disposed at roughly the same position as the manifold cavity 204 along the x-axis within the manifold body 200. For example, the vaporizer chamber 302 can be positioned at an opposite side 216 of the manifold body 200 from the substrate facing portion 208 of the manifold body 200 while the manifold cavity 204 is positioned in the substrate facing portion 208, and while both the vaporizer chamber 302 and the manifold cavity 204 may be positioned in the substrate exit side 226 of the manifold body 200.

Referring to FIGS. 4 and 5, the vaporizer 300 may include a vapor outlet 308. The vapor outlet 308 allows a semiconductor vapor to exit the vaporizer chamber 302. The vapor outlet 308 defines the first end of a vapor path within the manifold body 200. As seen in FIGS. 5 and 10, in some embodiments, the vapor outlet 308 may be defined as where the vaporizer 300 meets the first crossover 220. Alternatively, as seen in FIG. 4, the vapor outlet 308 may be a chamber narrower than the vaporizer chamber 302 which directs semiconductor vapor from the vaporizer chamber 302 into the second bore 260 or filter 500. In some embodiments, as seen in FIG. 4, the vapor outlet 308 leads the semiconductor vapor into the filter 500. In other embodiments, as seen in FIG. 5, the vapor outlet 308 leads the semiconductor vapor to the first crossover 220, which in turn leads the semiconductor vapor into the second bore 260 where the semiconductor vapor flows into the filter 500.

Referring to FIGS. 4 and 5, the vapor path within the manifold body 200 may include a filter 500. The filter 500 may be formed from a porous body having porous walls 502 that define a filter cavity 504. As seen in FIG. 4, the filter 500 may be housed within the second bore 260. In some embodiments, as depicted in FIG. 4, the filter 500 may be coaxial with the vaporizer 300 along the y-axis. Alternatively, as seen in FIG. 5, the filter 500 may be parallel to the vaporizer 300 with respect to the y-axis but not coaxial with the vaporizer 300 along the y-axis. In alternative embodiments, the filter 500 may be housed outside the manifold body 200, such as within an auxiliary manifold body in fluid communication with the manifold body 200.

The filter 500 may be a body composed of a porous and permeable material. The filter 500 may be composed of material having interconnected pores such that it is permeable and may have a permeability of at least about 2 × 10⁻⁸ cm². In some embodiments, the porous material has a permeability ranging from about 2 × 10⁻⁸ cm² to about 2 × 10⁻⁷ cm². In one non-limiting example, the porous material has a permeability of about 1 × 10⁻⁷ cm². Lower permeability can be used. However, when lower permeability is used, the filter 500 may have a larger area. The filter 500 may also be chemically inert at temperatures up to about 1,050 °C. The filter 500 includes porous walls 502 which act to filter particles out of a semiconductor vapor passing through the filter 500. The mean pore size (internal passages) of the filter 500 may be similar to the mean powder size or less, and the wall thickness of the porous walls 502 may be approximately at least 30x the mean pore size. The semiconductor vapor may be filtered by travelling through the porous walls 502 of the filter 500 to produce a filtered semiconductor vapor. Non-limiting examples of suitable porous materials include silicon carbide (SiC), porous graphite, mullite, electrically conductive ceramics, non-conductive ceramics, and fiberous materials such as ceramic fibers or graphite fibers. In one non-limiting example, the filter 500 is composed of a SiC member. The pore size in SiC is advantageous for filtering particles of semiconductor materials such as CdTe or CdSe at a temperature of less than about 1,000 °C.

In some embodiments, the filter 500 has a thermal conductivity in a range of from about 1 W/mK to about 40 W/mK. In one non-limiting example, the filter 500 has a thermal conductivity of about 26 W/mK. If the filter 500 has high thermal conductivity, the porous walls 502 may define all or a portion of the vaporizer 300. If the filter 500 has low thermal conductivity, vaporization may not occur within the filter 500, and the temperature within the filter 500 may not be kept hot enough to keep vaporized semiconductor material in the vapor phase, depending on the location of the heaters 400. In one non-limiting example, the filter 500 has a thermal conductivity of about 3 W/mK.

Referring to FIGS. 4 and 5, the filter 500 may include a first end 512 and a second end 514, where the filter cavity 504 extends between the inner surfaces 508 along the y-axis from the first end 512 to the second end 514. A filter through cap 516 and adhesive may be used to secure the first end 512 in place in the manifold body 200, and a filter end plug 518 and adhesive may be used to support the second end 514 in place in the manifold body 200. The filter through cap 516 and the filter end plug 518 may have respective portions 524, 526 which extend into the filter cavity 504. The filter end plug 518 may encircle the circumference of the filter 500 within the second bore 260. The filter through cap 516 and the filter end plug 518 may be configured so as to ensure that semiconductor vapor passing through the second bore 260 passes through the porous walls 502 of the filter 500. The filter 500 may include a filter inlet 520 through the filter through cap 516 at the first end 512, where semiconductor vapor may enter the filter cavity 504. In some embodiments, the filter inlet 520 is directly adjacent to the vapor outlet 308, as seen for example in FIG. 4. In other embodiments, such as depicted in FIG. 5, the first crossover 220 directs the semiconductor vapor from the first bore 250 to the second bore 260 where the semiconductor vapor may enter the filter 500.

The filter 500 may include a protective coating, such as an oxide coating. The protective coating may be applied through a vapor phase or may be wet-applied onto the surfaces of the porous walls 502 of the filter 500 as a liquid coating, or may be formed by thermal oxidation of the material of the filter 500. The protective coating serves to further aid in preventing the sourcing of contaminants from the filter 500. However, it is not necessary for the filter 500 to include a protective coating.

Referring to FIG. 4, a wall thickness of the filter 500 can be defined between the inner surface 508 and the outer surface 510 of the porous walls 502 of the filter 500. The semiconductor vapor can pass outwardly from the filter cavity 504 into the porous walls 502 of the filter 500 and into the second bore 260, or may pass inwardly from within the second bore 260 through the porous walls 502 of the filter and into the filter cavity 504. Semiconductor vapor may pass through the porous walls 502 several times while traveling along the vapor path within the manifold body 200. While passing through the porous walls 502, particles of a size big enough to be entrained in the semiconductor vapor and too big to have been vaporized in the vaporizer chamber 302 may be filtered out of the semiconductor vapor. The semiconductor material may be introduced into the vaporizer 300 in a mixture of particle sizes, for example ranging from about 1 micron to about 250 microns. In this example range, smaller particles tend to vaporize readily while larger particles tend to fall out of the carrier gas, and particles in the middle tend to be filtered out of the semiconductor vapor in the porous walls 502 of the filter 500. The middle-sized particles may be small enough to be entrained in the carrier gas, but big enough not to vaporize readily. When a particle is not vaporized, the particle may become a pinhole in the deposited semiconductor material, which results in a shunt and an electrical dead spot in a photovoltaic device which includes the semiconductor material. The filter 500 may act to make the semiconductor vapor more uniform by filtering out particle sizes which do not vaporize in the vaporizer chamber 302.

Referring to FIGS. 4 and 5, the filter 500 may be in fluid communication with the vaporizer 300 along the vapor path by virtue of the vapor outlet 308 and, in some embodiments, the first crossover 220. Vaporized and unvaporized semiconductor material may flow, with or without the aid of a carrier gas, from the vaporizer chamber 302 through the vapor outlet 308 and into the filter 500, where particles of the semiconductor powder which are entrained in the semiconductor vapor may be filtered out of the semiconductor vapor by flowing through the porous walls 502 of the filter 500. Thus, the filter 500 may produce a filtered semiconductor vapor.

In some embodiments, the filter 500 is not actively heated, and therefore may be referred to as a passive filter. Active heating of the filter 500 may be avoided by, for instance, by positioning the heater 400 outside of the vapor path. In some embodiments, such as as those depicted in FIGS. 6-9, the heater 400 is disposed outside the vapor path and is isolated from the filter 500 by the manifold body 200. In such embodiments, because the filter 500 is not actively heated, the filter 500 may be kept at a lower temperature than, for example, an actively-heated, combination vaporizer/filter such as that shown in FIG 2. In some embodiments, the filter 500 may be at a low enough temperature to prevent contaminant sourcing from materials which form the filter 500. For example, in some embodiments, the filter 500 is formed from silicon carbide (SiC). Generally, temperatures of from about 950 °C to about 1,050 °C may be utilized to flash vaporize semiconductor powders such as CdTe or CdSe. When heated to temperatures over about 1,050 °C, SiC may release silicon, which can result in defects in a semiconductor material deposited from the semiconductor vapor which has passed through the filter 500. However, when the filter 500 is not actively heated, the filter 500 may be kept below about 1,050 °C in use, and in doing so, the sourcing of silicon from the SiC may be substantially reduced or even eliminated. Therefore, in some embodiments, the filter 500 is kept at a temperature below about 1,050 °C. In some embodiments, the filter 500 is kept at a temperature below about 1,000 °C. To accomplish this, the heaters 400 are positioned or controlled to avoid or minimize directly heating the filter 500. Thus, the distributor assembly 100 may include a filter 500 which may be kept at a low enough temperature to accomplish filtering of the semiconductor vapor while not significantly contributing contaminants to the semiconductor vapor.

The filter 500 may be at a lower temperature than the vaporizer 300 because the filter 500 may be indirectly heated by virtue of the heater 400 being disposed outside the vapor path and isolated from the filter 500 by the manifold body 200, while vaporizer 300 may be directly or indirectly heated. Furthermore, the filter 500 may also be made of a less thermally conductive material than the vaporizer 300.

In use in some embodiments where the filter 500 is passively heated, the manifold body 200 may be about the same temperature as the filter 500, since the filter 500 does not generate any heat and may be heated only by heat transferring from the manifold body 200. In alternative embodiments, the filter 500 may be actively heated, such as by having a heating element within the filter cavity 504 or by conductively heating the porous walls 502. However, when the filter 500 is actively heated, it may result in the filter 500 being unevenly heated, which may allow for some areas of the filter 500 to overheat. When areas of the filter 500 overheat, it may result in contaminants sourcing from the filter 500. Thus, it is advantageous to passively heat the filter 500 by disposing the heater(s) 400 outside the vapor path and isolated from the filter 500 by the manifold body 200, although embodiments wherein the filter 500 is actively heated are nonetheless encompassed within the scope of the present disclosure. Thus, referring to FIGS. 6-10, the distributor assembly 100 may include heaters 400 which are isolated from the filter 500 by the manifold body 200. The heaters 400 provide heat to the manifold body 200, which may transfer the heat to the vaporizer 300 and the filter 500.

The location and number of the heaters 400 may vary. As seen in FIGS. 6-9, the distributor assembly 100 may include heaters 400 located below the manifold body 200 along the z-axis, between the manifold body 200 and the substrate 34 along the z-axis. As seen in FIGS. 6, 8, and 9, the distributor assembly 100 may include two heaters 400. As seen in FIG. 7, the distributor assembly may include four heaters 400. As described in more detail below, the heaters 400 may be disposed in vapor curtain beams 420 or in support beams 402, or both vapor curtain beams 420 and support beams 402, which may directly contact with the manifold body 200. Alternatively or additionally, the vapor curtain beams 420, in support beams 402, or both can be out of contact with the manifold body 200.

Referring now to FIG. 5, the filter 500 may include a filter outlet 522, which is an opening where semiconductor vapor within the filter cavity 504 may exit the filter 500. However, it is not necessary that the filter 500 include a filter outlet 522. Instead, as depicted in FIG. 4, the filter 500 may have a filter inlet 520 and may rely on the porous walls 502 to provide an exit for semiconductor vapor from the filter 500. Either way, once the semiconductor vapor exits the filter 500, the semiconductor vapor may flow, with or without the aid of a carrier gas, into the manifold cavity 204 via either the first crossover 220, as depicted in FIG. 4, or the second crossover 222, as depicted in FIG. 5.

Referring to FIGS. 4 and 5, the distributor assembly 100 may include a manifold cavity 204, which may be an elongated chamber within the manifold body 200. The manifold cavity 204 may be defined by the diameter Φ of the third bore 270 extending along the y-axis for some of the length L of the manifold body 200. In some embodiments, the manifold cavity 204 can have a diameter Φ of between about 40 mm and about 70 mm. In alternative embodiments, the manifold cavity 204 may be disposed within the manifold body 200 without being within one of the bores 250, 260, 270. For example, the manifold cavity 204 may simply be a chamber or a channel within a section of the manifold body 200 instead of being defined by some or all of the third bore 270. As seen in FIGS. 6-7, the manifold cavity 204 can have a substantially circular cross-section that is sized to promote the delivery and mixing of semiconductor vapor. However, a substantially circular cross-section is not necessary. For example, the manifold cavity 204 can have a rectangular cross-section.

In alternative embodiments, the manifold cavity 204 may be formed from a separate member defining a cavity that is inserted into the manifold body 200. In further alternative embodiments, the manifold cavity 204 may be coaxial with the filter 500, the vaporizer 300, or both the filter 500 and the vaporizer 300 along the y-axis within the manifold body 200.

Referring to FIGS. 4 and 5, the manifold cavity 204 may provide a flow path within the substrate facing portion 208 of the manifold body 200 for the distribution of semiconductor vapor via distribution jets 202 formed through the substrate facing portion 208 of the manifold body 200. The semiconductor vapor may flow from the filter 500, with or without the aid of a carrier gas, into the manifold cavity 204. The semiconductor vapor may flow through the first crossover 220, as depicted in FIG. 4, or the second crossover 222, as depicted in FIG. 5, to enter the manifold cavity 204 from the filter 500.

Referring to FIGS. 4 and 5, the manifold cavity 204 may extend along the y-axis between a first end 206 and a second end 218, with either the first crossover 220 or the second crossover 222 leading into one of the first end 206 or the second end 218. As seen in FIG. 4, the first crossover 220 may lead the semiconductor vapor from the filter 500 into the first end 206 of the manifold cavity 204. As seen in FIG. 5, the second crossover 222 may lead the semiconductor vapor from the filter 500 into the first end 206 of the manifold cavity 204. In alternative embodiments, the first crossover 220 or the second crossover 222 may be disposed so as to direct semiconductor vapor from the filter 500 into a middle section 232 of the manifold cavity 204.

Referring to FIGS. 4-10, semiconductor vapor within the manifold cavity 204 may flow, with or without the aid of a carrier gas, into the distribution jets 202. As seen in FIGS. 4, 5, and 9, the manifold cavity 204 may include a plurality of distribution jets 202, which are channels through the manifold body 200 from an inner surface 210 of the substrate facing portion 208 to an outer surface 212 of the substrate facing portion 208. In some embodiments, each distribution jet 202 can be formed as a hole machined through the substrate facing portion 208 of the manifold body 200, i.e., a hole that extends through the inner surface 210 of the substrate facing portion 208 and the outer surface 212 of the substrate facing portion 208. The distribution jets 202 may be configured to direct semiconductor vapor from the manifold cavity 204 in a desired direction, such as on a path out of the manifold body 200 which may include an exit slot 410. As seen in FIGS. 6-9, the distribution jets 202 can be positioned between the heaters 400 along the x-axis and above the heaters 400 relative to the substrate 34 along the y-axis. The distribution jets 202 define the second end of the vapor path within the manifold body 200.

Referring to FIG. 6, the flow of semiconductor vapor out of the manifold body 200 can be controlled by angled geometry of the distribution jets 202. Specifically, the distribution jets 202 can be directed at a distribution jet angle θ relative to the normal of the upwardly facing surface 46 of the substrate 34. In some embodiments, the distribution jet angle θ can be acute such as, for example, less than about 30° in one embodiment, or less than about 20° in another embodiment. As depicted in FIG. 6, the distribution jets 202 can be formed in a lip 214 of the manifold body 200, which can be angled upwards such that the distribution jets 202 provide for dispersion of semiconductor vapors before the semiconductor vapors condense on the substrate 34. The semiconductor vapor exiting the distribution jets 202 may contact surfaces of the manifold body 200 or vapor curtain beams 420 and spread out along the y-axis in the exit slot 410. In some embodiments, the semiconductor vapor forms a substantially uniform vapor curtain within the exit slot 410.

Referring to FIGS. 4-9, the distributor assembly 100 may include an exit slot 410. The exit slot 410 is an opening or channel which allows for semiconductor vapor to exit the manifold body 200 in a desired direction or along a desired path. The exit slot 410 may be configured to direct semiconductor vapor onto passing substrates 34, which can be transported on a path along the x-axis, underneath the distributor assembly 100 along the z-axis, on a rolling conveyor 44 or the like. In some embodiments, such as those depicted in FIGS. 4-5, the exit slot 410 includes an opening in the manifold body 200. In some embodiments, as depicted in FIG. 6, the exit slot 410 includes an opening between two support beams 402. In some embodiments, such as those depicted in FIGS. 7-9, the exit slot 410 includes an opening between two vapor curtain beams 420. In some embodiments, the semiconductor vapor may have a substantially uniform velocity along the z-axis within the exit slot 410.

As mentioned above, and referring to FIGS. 6-9, the distributor assembly 100 may include one or more heaters 400 configured to heat the manifold body 200 and thereby sufficiently heat the vaporizer chamber 302 to vaporize a semiconductor powder therein. Thus, the vaporizer 300 and the manifold body 200 can be separately heated, or can be heated by the same heater 400. For example, the heaters 400 can heat the lip 214 of the manifold body 200 and the areas of the manifold body 200 surrounding the distribution jets 202, as well as the vaporizer 300. In some embodiments, the heaters 400 can heat the lip 214 of the manifold body 200 and the area of the manifold body 200 surrounding the distribution jets 202 to a temperature of at least about 850 °C such as, for example, at least about 900 °C in one embodiment. For example, the portions of the manifold body 200 between the substrate facing portion 208 of the outer surface 212 and the manifold cavity 204 can be so heated. Accordingly, condensation of semiconductor vapor on the lip 214 and outer surface 212 of the manifold body 200 can be mitigated or avoided. The heaters 400 can be formed from electrically conductive material such as, for example, nichrome coils, silicon carbide tubes, or the like. For example, the heaters 400 can be formed from recrystallized SiC tubes. The heaters 400 can include resistance heating wires disposed inside a tube, such as SiC or nichrome heating wires within tubes formed from quartz or mullite. In some embodiments, each tube can contain multiple heating wires to form zones along the length L of the distributor assembly 100, as needed to achieve the desired temperature profile of the manifold body 200. For example, the wires can be divided into three zones, i.e., left, center, and right.

Referring to FIGS. 6-8, the heaters 400 may be supported on, attached to, or otherwise in thermal communication with the manifold body 200. In some embodiments, the heaters 400 are isolated from the filter 500 by the manifold body 200. In some embodiments, the heaters 400 are disposed outside the vapor path. In this manner, the filter 500 may be kept at a lower temperature than the vaporizer chamber 302 so as to prevent contaminant sourcing from the filter 500.

Referring to FIGS. 6-9, the distributor assembly 100 may include support beams 402 which may be configured to support the distributor assembly 100 above the substrate 34 along the z-axis. The mass of the manifold body 200, the vaporizer 300, and the heaters 400 can be carried by the support beams 402. Accordingly, the distributor assembly 100 can be suspended above the substrate 34 along the z-axis. The support beams 402 can be of a tubular shape having an elongated construction. In some embodiments, the beams 402 can have a substantially circular cross-section or a substantially rectangular cross-section. Accordingly, the support beams 402 can have an inner surface 404 surrounding a bore 428, and a thickness defined between the inner surface 404 and an outer surface 406. One or more heaters 400 may be housed within each support beam 402, in the bores 428 therein. Accordingly, the support beams 402 can be heated internally and the heaters 400 can be operated at operating temperatures described herein with low risk of impurity contamination. The support beams 402 may be composed of any suitable conductive material. Non-limiting example materials for the support beams 402 include graphite, SiC, mullite, and conductive ceramics.

Referring still to FIG. 6, the distributor assembly 100 may include two support beams 402 disposed a distance from one another along the x-axis to form the exit slot 410 therebetween. Each of the support beams 402 can have a slot bounding face 412 that bounds the exit slot 410 and may be a substantially flat side of the support beam 402. The support beams 402 may have a substantially rectangular cross-section, and the slot bounding face 412 may be a substantially flat portion of the outer surface 406 of the support beam 402. However, the support beams 402 may have cross-sections of other shapes, such as circular cross-sections, and therefore the slot bounding face 412 may not be flat.

Referring still to FIG. 6, the manifold body 200 may be disposed above the support beams 402 along the z-axis relative to the substrates 34 such that the distribution jets 202 terminate in, or immediately adjacent to, the exit slot 410 between the support beams 402. Accordingly, semiconductor vapor can flow from the manifold cavity 204 of the manifold body 200 into the exit slot 410 via the distribution jets 202. The distribution jet angle θ can promote mixing of the semiconductor vapor prior to being directed towards the substrate 34 via the exit slot 410. The semiconductor vapor may pass through the exit slot 410 between the support beams 402 before being deposited onto the substrate 34.

In some embodiments, the outer surface 406 of the support beams 402 or vapor curtain beams 420 can be coated with a low emissivity coating such as, for example, Al₂O₃, Y₂O₃, or the like. Specifically, the substrate facing portions 408 of the outer surface 406 can be coated with the low emissivity coating. As a result, the emission of radiant thermal energy from the support beams 402 can be reduced and heat transfer from the heaters 400 to the substrate 34 can be reduced. The manifold body 200 may also be coated with a low emissivity coating.

As seen in FIG. 6, each support beam 402 may include a bore 428 therein which may house a heater 400. The heaters 400 may be, for instance, recrystallized SiC tubes. The outer surface 406 of each support beam 402 can be in direct contact with the substrate facing portion 208 of the outer surface 212 of the manifold body 200. Accordingly, the support beams 402 can transfer heat to the manifold body 200 via thermal conduction sufficient to vaporize semiconductor powder within the vaporizer chamber 302. Furthermore, the direct contact and thermal conduction between the manifold body 200 and the support beams 402 can be provided adjacent to the distribution jet 202. As a result, the lip 214 and exit slot 410 of the manifold body 200 may also be heated by the heaters 400 within the support beams 402 so as to ensure that semiconductor vapor exiting the distribution jets 202 and flowing through the exit slot 410 remains in the vapor phase. Thus, heating for the vaporizer 300, the lip 214, and the exit slot 410 can be provided using the same heaters 400. However, heating for the vaporizer 300, the lip 214, and the exit slot 410 can alternatively be provided separately. The support beams 402 can reduce the risk of unwanted corrosion of, and contamination from, the heaters 400. Additionally, the support beams 402 can further define the exit slot 410 therebetween.

Referring to FIGS. 6-9, while each of the heaters 400 within the distributor assembly 100 may provide heat for the vaporizer 300, the heaters 400 may also provide heat to other areas of the manifold body 200 so as to prevent condensation. For example, the heaters 400 may provide heat to the lip 214 of the manifold body 200, as well as the outer surface 406 of the support beams 402, and the channel surfaces 430 of the vapor curtain beams 420 so as to prevent condensation of the semiconductor vapor on the lips 214 and while within the exit slot 410. The heater 400 which heats the vaporizer 300 may be the same heater 400 which heats the lip 214 and the outer surfaces 406 and the channel surfaces 430, but need not be.

The heaters 400 may be embedded within support structures such as support beams 402 or vapor curtain beams 420, or may alternatively be disposed within the manifold body 200, but may be out of the vapor path and isolated from the filter 500 by the manifold body 200. As seen in FIG. 6, the heaters 400 may be disposed within support beams 402 that directly contact the manifold body 200. As seen in FIG. 7, heaters 400 may be disposed within vapor curtain beams 420 that directly contact the manifold body 200. As seen in FIG. 7, heaters 400 may be disposed within support beams 402 which are isolated from the manifold body 200 by the vapor curtain beams 420. Regardless of location, the heaters 400 may be run at a temperature of from about 1,000 °C to about 1,100 °C.

FIG. 6 illustrates an embodiment of the distributor assembly 100 wherein heaters 100 are housed within bores 428 of the support beams 402, which are in direct contact with the manifold body 200. The heaters 400 embedded in support beams 402 may be disposed below the manifold body 200 along the z-axis, between the manifold body 200 and the substrate 34 along the z-axis. FIGS. 7-9 show embodiments of the distributor assembly 100 which include heaters 400 embedded within vapor curtain beams 420, housed in bores 422 therein, where the vapor curtain beams 420 are in direct contact with the manifold body 200. Thus, the heaters 400 may be disposed within bores 422 in vapor curtain beams 420 or within bores 428 in support beams 402, or within both bores 422 and bores 428.

Referring now to FIGS. 7-9, the distributor assembly 100 may include vapor curtain beams 420 disposed a distance w along the x-axis apart from each other to define the exit slot 410 therebetween. The vapor curtain beams 420 may be bodies of thermally conductive material that can be machined from materials such as, but not limited to, graphite, CFC, or the like. The vapor curtain beams 420 may be elongated along the z-axis compared to the x-axis. In other words, the vapor curtain beams 420 may have a substantially recetangular Z-X cross-section. In some embodiments, such as those depicts in FIGS. 7-8, the vapor curtain beams 420 may be elongated along the z-axis compared to the x-axis whereas the support beams 402 have a substantially square Z-X cross-section. The vapor curtain beams 420 may be disposed adjacent to, and in direct contact with, the outer surface 212 of the substrate facing portion 208 of the manifold body 200. The vapor curtain beams 420 may also, or alternatively, be adjacent to, and in direct contact with, support beams 402. The vapor curtain beams 420 may provide structural support for the manifold body 200. The vapor curtain beams 420 may also provide locations for heaters 400. For example, as shown in FIGS. 6-9, heaters 400 may be disposed within bores 422 within the vapor curtain beams 420. The bores 422 may be in direct contact with the manifold body 200, as seen in FIGS. 7-9, so as to provide sufficient heat to vaporize semiconductor powder within the vaporizer chamber 302. Furthermore, the heaters 400 within bores 422 may provide sufficient heat to the exit slot 410 to ensure that semiconductor vapor flowing through the exit slot remains in the vapor phase.

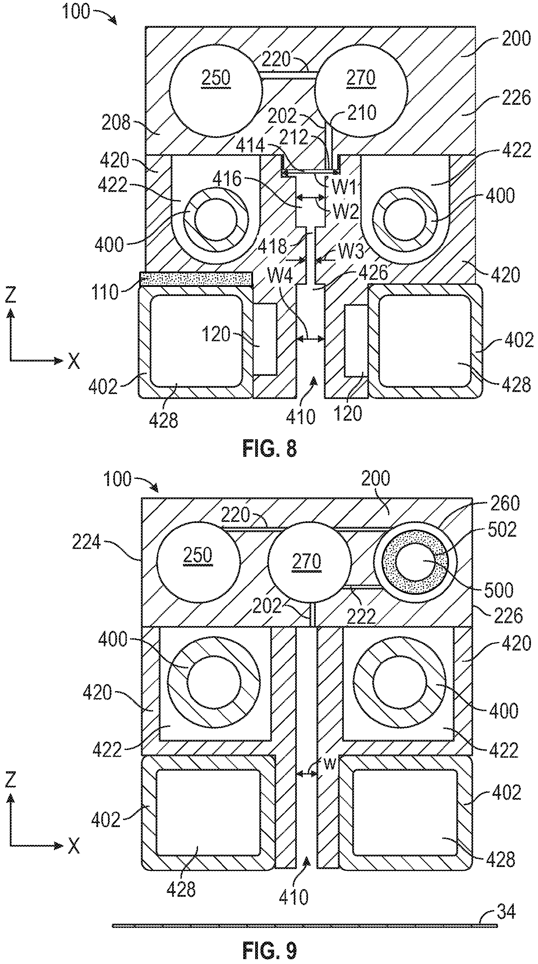

Referring to FIGS. 7-8, the distance w may vary with position along the z-axis. Thus, as seen in FIG. 8, the exit slot 410 may include a first section 414 having a first width w₁, a second section 416 having a second width w₂, a third section 418 having a third width w₃, and a fourth section 426 having a fourth width w₄, where two or more of the widths w₁, w₂, w₃, w₄ may be the same but need not be the same. The widths w₁, w₂, w₃, w₄ may vary monotonically (i.e., increasingly become wider or increasingly become less wide as position along the z-axis changes), or may vary non-monotonically, where for instance the first width w₁ is greater than the second width w₂ but less than the fourth width w₄. Having a plurality of widths w₁, w₂, w₃, w₄ may help the semiconductor vapor within the exit slot 410 form a substantially uniform vapor curtain. For example, when vapor exits the distribution jets 202 and enters the first section 414, the semiconductor vapor may contact one or more surfaces of vapor curtain beam 420 to help disperse the semiconductor vapor into a more uniform sheet. Each time the semiconductor vapor enters a section having a different width, surfaces of the vapor curtain beams 420 may be contacted by the semiconductor vapor to further aid in merging semiconductor vapors from the distribution jets 202 and dispersing the semiconductor vapors into a substantially uniform vapor curtain within the exit slot 410.

As seen in FIG. 8, the vapor curtain beams 420 may further include one or more nozzle temperature control channels 120, which are channels in the vapor curtain beams 420 in an area nearby the exit slot 410 or nearby support beams 402. The temperature control channels 120 may prevent overheating of the support beams 402, so as to prevent contaminant sourcing from the support beams 402. The temperature control channels 120 may also prevent overheating of the vapor curtain beams 420. Furthermore, the temperature control channels 120 may affect the temperature of the exit slot 410. The temperature control channels 120 may effectively make the exit slot 410 slightly cooler than the exit slot 410 would be without the temperature control channels 120, because the presence of the temperature control channels 120 means that conductive material, which transfers heat from heaters 400 to the exit slot 410, is omitted from the vapor curtain beams 420 in areas nearby the exit slot 410.

Referring to FIGS. 7-9, the vapor curtain beams 420 may be disposed between the manifold body 200 and the support beams 402 along the z-axis. The support beams 402 may be disposed between the vapor curtain beams 420 and the substrate 34 along the z-axis. As seen in FIGS. 7-9, the vapor curtain beams 420 may be disposed directly in contact with the support beams 402. The support beams 402 may provide structural support for the vapor curtain beams 420.

Referring to FIG. 7, an embodiment of the distributor assembly 100 may include four heaters 400 disposed in bores 422 of vapor curtain beams 420 and bores 428 of support beams 402, where the bores 422 of the vapor curtain beams 420 are in direct contact with the manifold body 200 but the bores 428 of the support beams 402 are not in direct contact with the manifold body 200. Rather, bores 428 of the support beams 402 may be completely encircled by the support beams 402, and the support beams 402 may be in direct contact with the vapor curtain beams 420. The heaters 400 in the support beams 402 may provide heat to the vapor curtain beams 420 in areas adjacent to the exit slot 410 so as to provide heat to areas of the exit slot 410. Similarly, the heaters 400 in the bores 422 of the vapor curtain beams 428 may also provide heat to the exit slot 410 by heating areas of the vapor curtain beams 420 adjacent to the exit slot 410, in addition to providing heat to the manifold body 200 by virtue of the bores 428 being in direct contact with the manifold body 200.

Referring now to FIG. 6, the semiconductor vapor may flow from the manifold body 200 through the exit slot 410 between the support beams 402 housing heaters 400 in bores 428 therein. Alternatively, as shown in FIGS. 7-9, the semiconductor vapor may flow from the manifold body 200 through the exit slot 410 between the vapor curtain beams 420, where the support beams 420 are separated from the exit slot 410 along the x-axis by the vapor curtain beams 420. The support beams 402 may be in direct contact with the vapor curtain beams 420. In the embodiments shown in FIGS. 7-9, the vapor curtain beams 420 are disposed between the support beams 420 and the exit slot 410 along the x-axis.

Referring to FIGS. 8 and 9, the support beams 402 need not house heaters 400. Rather, the bores 428 may be empty or filled with a non-heating substance, and the support beams 402 may act as structural support for the manifold body 200 or the vapor curtain beams 420 without providing additional heat. Furthermore, as seen in FIG. 8, thermal insulation 110 may be disposed between the support beams 402 and the vapor curtain beams 420, or elsewhere in contact with the vapor curtain beams 420 or the support beams 402. The thermal insulation 110 may be any suitable material which is less conductive than the material of the vapor curtain beams 420 or the support beams 402. The thermal insulation 110 may also act to reduce the temperature in the exit slot 410. The distributor assembly 100 can also be substantially surrounded by thermal insulation 110. In some embodiments, the thermal insulation 100 can be in contact with the outer surface 212 of the manifold body 200. For example, the thermal insulation 110 can be in contact with one or more faces 228, 230 of the outer surface 212. The mass or load of the thermal insulation 110 can be supported by the vapor curtain beams 420 or the support beams 402.

Referring to FIGS. 9 and 10, the distributor assembly 100 may include three bores 250, 260, 270 in the manifold body 200, where the first bore 250 houses the vaporizer 300, the second bore 260 houses the manifold cavity 204, and the third bore 270 houses the filter 500. As seen in FIG. 10, the manifold cavity 204 may be positioned between the vaporizer 300 and the filter 500 along the x-axis. The three bores 250, 260, 270 may be linearly aligned within the manifold body 200 at the same position along the z-axis, resulting in the vaporizer 300, filter 500, and manifold cavity 204 being substantially co-planar within the manifold body 200 along the z-axis.

Referring to FIG. 9, an embodiment of the distributor assembly 100 may have the first bore 250, second bore 260, and third bore 270 disposed within the manifold body 200 at the same position along the z-axis. The distributor assembly 100 may further have an exit slot 410 with a width w that does not change with position along the z-axis between the vapor curtain beams 420. The first crossover 220 may be parallel with the second crossover 222 with respect to the x-axis. The bores 422 within the vapor curtain beams 420 which house heaters 400 may be in direct contact with the manifold body 200 so as to heat the manifold body sufficiently to vaporizer semiconductor vapor within the vaporizer chamber 302.

Referring to FIG. 10, the first bore 250 may extend a longer distance along the y-axis within the manifold body 200 than the second bore 260 and the third bore 270. The manifold cavity 204 may be positioned in a mid-region 240 of the manifold body 200, between the vaporizer 300 and the filter 500 along the x-axis, despite the vapor path traveling from the vapor outlet 308 and through the filter 500 before reaching the manifold cavity 204. The first crossover 220 may extend for a greater distance along the x-axis than the second crossover 222.

Referring collectively to FIGS. 4-10, in use, a feed of semiconductor powder may be introduced into the distributor assembly 100 through the injection port 304 with the powder injector 306, where the semiconductor powder enters the vaporizer 300 and is vaporized into a semiconductor vapor within the vaporizer chamber 302, which is hot enough to vaporize the semiconductor powder because of heat generated from the heaters 400 and transferred to the vaporizer 300 by virtue of the thermally conductive material of the manifold body 200. The semiconductor vapor may be carried through the distributor assembly 100 by an inert carrier gas, or may flow through the distributor assembly 100 without the aid of a carrier gas. For example, the semiconductor material powder can be transported by a carrier gas through the vaporizer chamber 302, out the vapor outlet 308, into the filter 500, into the manifold cavity 204, and then through the distribution jets 202 on a path out of the manifold body 200, which may include an exit slot 410 between vapor curtain beams 420 or support beams 402, toward a substrate 34 onto which the semiconductor vapor is deposited to form a semiconductor layer. While flowing through the filter 500, the semiconductor material is filtered to remove particles which are entrained in the semiconductor vapor but were not vaporized in the vaporizer chamber 302. One or more heaters 400 heats the manifold body 200 so as sufficiently heat the vaporizer chamber 302 to vaporize semiconductor material therein, and so as to prevent condensation of the semiconductor vapor on the lip 214 of the manifold body 200 or in the exit slot 410. The heater 400 which heats the vaporizer 300 may be the same heater 400 which heats the manifold body 200, but need not be. The heater 400 is isolated from the filter 500 by the manifold body 200 so as to not actively heat the filter 500. In this manner, the filter 500 may be kept at a low enough temperature to prevent sourcing of contaminants from the filter 500 while still being kept hot enough to maintain the semiconductor vapor in the vapor phase while the semiconductor vapor flows through the filter 500.

A vapor path is defined through the distributor assembly 100 as beginning at the vapor outlet 308 of the vaporizer 300, and ending at the distribution jets 202. From the vapor outlet 308, the semiconductor vapor may flow into the filter 500, wherein the semiconductor vapor may flow through the filter cavity 504 and through the pores in the porous walls 502 of the filter 500. To get from the vaporizer 300 to the filter 500, the vapor may flow through a first crossover 220 in the manifold body 200, or, alternatively, may flow directly into the filter 500 from the vapor outlet 308. The semiconductor vapor may continue to flow from the filter 500 to the manifold cavity 204. To get from the filter 500 to the manifold cavity 204, the vapor may flow through a second crossover 222 in the manifold body 200. In alternative embodiments, the semiconductor vapor may flow directly from the filter 500 into the manifold cavity 204. The semiconductor vapor may continue to flow from the manifold cavity 204 through distribution jets 202, where the vapor path within the manifold body 200 ends. From the distribution jets 202, the vapor may be directed into an exit slot 410 so as to flow out of the manifold body 200 or otherwise on a desired path toward a substrate 34. In some embodiments, the heaters 400 are positioned outside of the vapor path.

The vapor path within the manifold body 200 is readily seen in FIG. 10. Referring to FIG. 10, semiconductor powder may be vaporized into a semiconductor vapor within the vaporizer chamber 302 in the first bore 250. The semiconductor vapor may flow through the first crossover 220 into the second bore 260, where the semiconductor vapor is forced to flow through the porous walls 502 of the filter 500 and into the filter cavity 504 before exiting the filter 500 at the second end 514. Once out of the filter 500, the semiconductor vapor may flow through the second crossover 222 into the third bore 270, where the semiconductor vapor enters the manifold cavity 204 and flows into distribution jets 202, where the vapor path within the manifold body 200 ends.

Advantageously, use of the distributor assembly 100 described herein may provide for the filtering of a semiconductor vapor without the addition of contaminants from the apparatus used to filter the semiconductor material. Thus, also provided herein is a method of conducting vapor transport deposition that involves vaporizing a semiconductor material in a distributor assembly 100 within a vaporizer chamber 302, filtering the semiconductor vapor with a filter 500 composed of a porous material, where the filter 500 is not actively heated, and allowing the vaporized semiconductor material to be deposited onto a substrate 34 moving past the distributor assembly 100. The semiconductor vapor which is not deposited on the substrate 34 may coat the rollers, insulation, or other parts of the distributor assembly 100. In some embodiments of the method, a heater 400 is utilized to heat both the vaporizer 300, so as to vaporize semiconductor material powder within the vaporizer chamber 302, and the manifold body 200, so as to prevent condensation of the semiconductor material on the manifold body 200, as well as the exit slot 410 to maintain the semiconductor vapor in the vapor phase while within the exit slot 410.

Various other features may be included in the distributor assembly 100. For example, cradles for suspending the distributor assembly 100 may be provided, such as in cold zones of the distributor assembly 100. The distributor assembly 100 can be relatively easy to manufacture, requiring minimal machining.

According to the embodiments provided herein, a distributor assembly 100 can include a manifold body 200 having a vaporizer 300, a filter 500, and a manifold cavity 204. In some embodiments, the filter 600 is passively heated so as to prevent contaminant sourcing from the material of the filter 500. The manifold body 200 can include distribution jets 202 extending through the inner surface 210 and an outer surface 212 of the manifold body 200 from the manifold cavity 204 into an exit slot 410. The filter 500 can receive semiconductor vapor from the vaporizer 300. The manifold cavity 204 can receive the semiconductor vapor from the filter 500. The semiconductor vapor can flow from the manifold cavity 204 through the distribution jets 202. The heater 400 can be configured to heat the vaporizer 300, and can be isolated from the filter 500 by the manifold body 200 so as to only indirectly heat the filter 500. The heater 400 can be located outside the vapor path. The filter 500 may be kept at a temperature lower than the vaporizer 300, but hot enough to maintain a semiconductor vapor in the vapor phase while inside the filter 500.

Certain embodiments of the distributor assembly and methods disclosed herein are defined in the above examples. It should be understood that these examples, while indicating particular embodiments, are given by way of illustration only. From the above discussion and these examples, one skilled in the art can ascertain the essential characteristics of this disclosure, and without departing from the spirit and scope thereof, can make various changes and modifications to adapt the compositions and methods described herein to various usages and conditions. Various changes may be made and equivalents may be substituted for elements thereof without departing from the essential scope of the disclosure. In addition, many modifications may be made to adapt a particular situation or material to the teachings of the disclosure without departing from the essential scope thereof.

Various preferred features and embodiments of the present invention will now be described with reference to the following numbered paragraphs (paras).
1. A distributor assembly comprising:
   a manifold body comprising distribution jets for directing a semiconductor vapor from the manifold body;
   a vaporizer chamber formed in the manifold body, wherein the vaporizer chamber comprises a powder inlet and a vapor outlet;
   a powder injector disposed in the powder inlet for delivering semiconductor powder to the vaporizer chamber;
   a vapor path formed through the manifold body, wherein the vapor path comprises a first end disposed at the vapor outlet of the vaporizer chamber and a second end disposed at the distribution jets;
   a filter disposed within the vapor path, wherein the filter comprises a porous body that defines a filter cavity; and
   a heater configured to heat the manifold body and isolated from the filter by the manifold body, wherein the heater heats the vaporizer chamber, whereby the semiconductor powder is transformed into the semiconductor vapor.
2. The distributor assembly of para 1, wherein an exit slot is defined between support beams or vapor curtain beams in contact with the manifold body, wherein the exit slot is configured to lead semiconductor vapor from the distribution jets out of the manifold body.
3. The distributor assembly of para 1, further comprising a first crossover configured to direct semiconductor vapor from the vaporizer chamber to the filter or from the filter to a manifold cavity.
4. The distributor assembly of para 2, further comprising a second crossover configured to direct semiconductor vapor from the filter to the manifold cavity, wherein the first crossover is configured to direct semiconductor vapor from the vaporizer chamber to the filter.
5. The distributor assembly of para 1, wherein the manifold body comprises a manifold cavity in the vapor path between the filter and the distribution jets.
6. The distributor assembly of para 1, wherein the vaporizer chamber and the filter are coaxial.
7. The distributor assembly of para 1, further comprising a filter through cap at a first end of the filter and a filter end plug at a second end of the filter, wherein the filter through cap and the filter end plug are configured to ensure that semiconductor vapor flowing through the vapor path passes through the porous body.
8. The distributor assembly of para 1, further comprising a feed tube retainer configured to to hold the powder injector in the powder inlet.
9. The distributor assembly of para 1, wherein the manifold body comprises graphite and the porous body comprises silicon carbide (SiC) or mullite.
10. A distributor assembly comprising:
   a manifold body comprising distribution jets for directing a semiconductor vapor from the manifold body;
   a vaporizer chamber formed as a first bore within the manifold body, wherein the vaporizer chamber comprises a vapor outlet;
   a vapor path comprising a second bore formed through the manifold body, wherein the vapor path comprises a first end disposed at the vapor outlet of the vaporizer chamber and a second end disposed at the distribution jets;
   a filter in the second bore of the manifold body comprising a porous body defining a filter cavity; and
   a heater configured to heat the manifold body and isolated from the filter by the manifold body.
11. The distributor assembly of para 10, wherein the heater is disposed within a vapor curtain beam in contact with the manifold body or a support beam in contact with the manifold body.
12. The distributor assembly of para 10, wherein the first bore and the second bore are coaxial within the manifold body.
13. The distributor assembly of para 10, wherein the distribution jets comprise channels within the manifold body extending from an inner surface of a substrate facing portion of the manifold body to an outer surface of the substrate facing portion.
14. The distributor assembly of para 10, further comprising two vapor curtain beams disposed adjacent to the manifold body, wherein an exit slot is defined between the two vapor curtain beams, the exit slot being configured to direct semiconductor vapor from the distribution jets toward a substrate.
15. The distributor assembly of para 14, wherein temperature control channels are defined within the vapor curtain beams, the temperature control channels being configured to affect a temperature in the exit slot.
16. The distributor assembly of para 14, further comprising a manifold cavity defined by a third bore within the manifold body, wherein the semiconductor vapor may enter the distribution jets from the manifold cavity.
17. A method of depositing a semiconductor vapor on a substrate, the method comprising:
   vaporizing a semiconductor powder into a semiconductor vapor in a vaporizer chamber at a first temperature;
   carrying the semiconductor vapor with a carrier gas into a filter at a second temperature, wherein the filter comprises a porous body and causes particles to filter out of the semiconductor vapor to produce a filtered semiconductor vapor, wherein the second temperature is less than the first temperature; and
   depositing the filtered semiconductor vapor onto a substrate.
18. The method of para 17, wherein the first temperature is in a range of from about 950 °C to about 1,050 °C.
19. The method of para 17, wherein the second temperature is less than about 1,000 °C.
20. The distributor assembly of any of paras 1-16, further comprising a support beam in contact with the manifold body, wherein the support beam houses the heater.
21. The distributor assembly of any of paras 1-16 or 20, further comprising thermal insulation in a support beam or a vapor curtain beam.
22. The distributor assembly of para 21, wherein the thermal insulation comprises a material less thermally conductive than graphite.
23. The distributor assembly of any of paras 1-16 or 20-22, comprising four heaters disposed in bores within support beams and/or vapor curtain beams.
24. The distributor assembly of any of paras 1-16 or 20-23, wherein the porous body has a permeability of at least about 2 × 10⁻⁸ cm².
25. The distributor assembly of any of paras 1-16 or 20-24, wherein the porous body has a permeability in a range of from about 2 × 10⁻⁸ cm² to about 2 × 10⁻⁷ cm².
26. The distributor assembly of any of paras 1-16 or 20-25, wherein the porous body has a permeability of about 1 × 10⁻⁷ cm².
27. The distributor assembly of any of paras 1-16 or 20-26, wherein the heater is disposed in a support beam or a vapor curtain beam comprising a thermally conductive material.
28. The distributor assembly of para 27, wherein the heater is disposed in a support beam and the thermally conductive material comprises SiC, or wherein the heater is disposed in a vapor curtain beam and the thermally conductive material comprises graphite.
29. The distributor assembly of any of paras 1-16 or 20-28, wherein the filter has a thermal conductivity in a range of from about 1 W/mK to about 40 W/mK.
30. The distributor assembly of any of paras 1-16 or 20-29, wherein the filter has a thermal conductivity of about 26 W/mK.
31. The distributor assembly of any of paras 1-16 or 20-30, further comprising one or more support beams or vapor curtain beams adjacent to the manifold body, wherein the support beams or vapor curtain beams comprise a second thermally conductive material.
32. The distributor assembly para 31, wherein the support beams comprise the second thermally conductive material and the second thermally conductive material comprises SiC, or wherein the vapor curtain beams comprise the second thermally conductive material and the second thermally conductive material comprises graphite.
33. The distributor assembly of any of paras 1-16 or 20-32, wherein the filter is in fluid communication with the manifold cavity via a cross over defining a channel in the manifold body.
34. The distributor assembly of any of paras 1-16 or 20-33, wherein an outer surface of the manifold body, a support beam, or a vapor curtain beam is coated with a low emissivity coating.
35. The distributor assembly of para 34, wherein the low emissivity coating comprises Al₂O₃ or Y2O3.
36. The distributor assembly of any of paras 1-16 or 20-35, comprising a distribution jet disposed at an angle relative to the normal of a substrate.

## Claims

1. A method of depositing a semiconductor vapor on a substrate (13,34), the method comprising:
vaporizing a semiconductor powder into a semiconductor vapor in a vaporizer chamber (302) at a first temperature;
carrying the semiconductor vapor with a carrier gas into a filter (500) at a second temperature, wherein the filter (500) comprises a porous body and causes particles to filter out of the semiconductor vapor to produce a filtered semiconductor vapor, wherein the second temperature is less than the first temperature; and
depositing the filtered semiconductor vapor onto the substrate (13,34).

2. The method of claim 1, wherein the first temperature is in a range of from about 850 °C to about 1,150 °C.

3. The method of claim 1, wherein the first temperature is in a range of from about 950 °C to about 1,050 °C.

4. The method of claim 1, wherein the second temperature is less than about 1,050 °C.

5. The method of claim 1, wherein the second temperature is less than about 1,000 °C.

6. The method of any preceding claim, comprising:
heating a vaporizer (300) with one or more heaters (400), wherein the vaporizer (300) defines the vaporizer chamber (302).

7. The method of any preceding claim, comprising:
distributing the filtered semiconductor vapor by a plurality of distribution jets (202).

8. The method of any preceding claim, wherein the filter (500) is passively heated.

9. The method of any of claims 6-8, wherein the vaporizer chamber (302) is heated to the first temperature by conduction with the one or more heaters (400).

10. The method of any of claims 6-9, wherein the filter (500) is isolated from the one or more heaters (400).

11. The method of any of claims 6-10, wherein the vaporizer (300) has a thermal conductivity of at least 1 W/mK.
